(19)

Europäisches
Patentamt

European
Patent Office

Office européen
des brevets

(11)  **EP 2 214 220 A1**

(12)  **EUROPEAN PATENT APPLICATION**
published in accordance with Art. 153(4) EPC

(43) Date of publication:
**04.08.2010  Bulletin 2010/31**

(51) Int Cl.:
***H01L 35/32*** *(2006.01)*    ***H01L 35/34*** *(2006.01)*

(21) Application number: **08840062.7**

(22) Date of filing: **09.10.2008**

(86) International application number:
**PCT/JP2008/068811**

(87) International publication number:
**WO 2009/051208 (23.04.2009 Gazette 2009/17)**

(84) Designated Contracting States:
**AT BE BG CH CY CZ DE DK EE ES FI FR GB GR
HR HU IE IS IT LI LT LU LV MC MT NL NO PL PT
RO SE SI SK TR**
Designated Extension States:
**AL BA MK RS**

(30) Priority: **18.10.2007  JP 2007271651**

(71) Applicant: **Sumitomo Chemical Company, Limited
Tokyo 104-8260 (JP)**

(72) Inventors:
• **HIROYAMA, Yuichi
Tsukuba-shi
Ibaraki 300-2617 (JP)**

• **SADAOKA, Kazuo
Toyonaka-shi,
Osaka 561-0802 (JP)**
• **SAWABE, Yoshinari
Tsukuba-shi
Ibaraki 300-4232 (JP)**

(74) Representative: **Hart-Davis, Jason et al
Cabinet Beau de Loménie
158, rue de l'Université
75340 Paris Cedex 07 (FR)**

(54)  **THERMOELECTRIC CONVERSION ELEMENT, THERMOELECTRIC CONVERSION MODULE USING THE THERMOELECTRIC CONVERSION ELEMENT, AND MANUFACTURING METHOD FOR THE THERMOELECTRIC CONVERSION MODULE**

(57)      Provided are a thermoelectric conversion element, a thermoelectric conversion module using the thermoelectric conversion element, and a method for manufacturing the thermoelectric conversion module. The thermoelectric conversion element has a hexahedral shape, of which the two faces opposing each other and the other four faces have different reflectances to light. The thermoelectric conversion module comprises a plurality of p-type thermoelectric conversion elements and a plurality of n-type thermoelectric conversion elements, and a plurality of electrodes connecting the end faces of each pair of the p-type thermoelectric conversion elements and the n-type thermoelectric conversion elements electrically with each other to connect the p-type thermoelectric conversion elements and the n-type thermoelectric conversion elements electrically in series alternately. At least one of the n-type thermoelectric conversion elements and the p-type thermoelectric conversion elements has a hexahedral shape, of which the two faces opposing each other and the other four faces have different reflectances to light, and of which the two faces opposing each other are individually jointed to the electrodes.

*Fig.1*

EP 2 214 220 A1

# Description

## Technical Field

The present invention relates to a thermoelectric conversion element, a thermoelectric conversion module using the thermoelectric conversion element, and a method for manufacturing the thermoelectric conversion module.

## Background Art

Many thermoelectric conversion elements have anisotropy, and in order that a thermoelectric conversion element generates electricity most efficiently, a temperature difference needs to be applied in a specific orientation in the thermoelectric conversion element. Accordingly, in order to enhance the efficiency of a thermoelectric conversion module, it is necessary to match the direction of a flow of heat in the thermoelectric conversion module in a specific orientation to which the temperature difference in the thermoelectric conversion element constituting this thermoelectric conversion module should be applied (hereinafter referred to as specific orientation).

In order to arrange p-type and n-type thermoelectric conversion elements so as to be aligned in a specific orientation, Japanese Unexamined Patent Application Publication No. 2007-509498 discloses making the shape of each thermoelectric conversion element at a prismatic body of a regular hexagon, specifically making a surface shape of the thermoelectric conversion element a prismatic body whose top face and bottom face are regular hexagonal and side faces are rectangular in surface shape. The specific orientation of such thermoelectric conversion elements is recognized by using a difference of the surface shape between the regular hexagon and the rectangle, and a plurality of thermoelectric conversion elements are arranged by using a robot, for instance, with their specific orientation aligned in the direction of a flow of heat.

## Disclosure of the Invention

However, the shape of a thermoelectric conversion element, such as the cross-sectional area and the height, needs to be optimized according to the characteristics of the materials constituting the thermoelectric conversion element or the structure of a module, and it is not appropriate to design the surface shape of the thermoelectric conversion element only for the purpose of easily detecting its specific orientation.

For this reason, the present invention is directed at providing a thermoelectric conversion element whose specific orientation is easily arranged in the direction of a flow of heat even when the specific orientation is difficult to be recognized from the surface shape of the thermoelectric conversion element, a thermoelectric conversion module using the thermoelectric conversion element, and a method for manufacturing the thermoelectric conversion module.

A thermoelectric conversion element according to the present invention is hexahedral in shape and two faces opposing each other are different in reflectance to light from the other four faces.

According to the present invention, by using a difference in reflectance to light between two opposing faces and the other four faces of a thermoelectric conversion element which is hexahedral in shape, a specific orientation of a thermoelectric conversion element in which orientation a temperature difference should be applied can be recognized, and the specific orientations of the thermoelectric conversion elements can be easily arranged so as to be aligned along the flow of heat. Here, the specific orientation in which a temperature difference should be applied, means an orientation such that when a temperature difference is applied to the thermoelectric conversion element in parallel to the orientation, the thermoelectric conversion characteristics such as especially a thermal electromotive force and an electric current value can be enhanced more in comparison with a case in which the temperature difference is applied to another orientation. The specific orientation in which this temperature difference should be applied may be determined, for instance, by previously measuring the thermoelectric conversion characteristics in individual orientations of the thermoelectric conversion element. More specifically, in a thermoelectric conversion element, the thermoelectric conversion characteristics depend on Z determined by the following formula (1), in other words, the value of a performance index, and the larger the value is, the more adequate the thermoelectric conversion characteristics are considered to be. In the present invention, an orientation showing the highest value among the Z values of individual orientations of the thermoelectric conversion element may be determined to be the specific orientation.

$$Z = \alpha^2 \times \sigma/\kappa \qquad (1)$$

, wherein Z represents a value of a performance index; $\alpha$ represents a value of a Seebeck coefficient; $\sigma$ represents a value of electrical conductivity; and $\kappa$ represents a value of thermal conductivity.

It is preferable that the thermoelectric conversion element contain a metal oxide.

The hexahedron is preferably a rectangular parallelepiped, and more preferably a cube. In the present invention, the hexahedron such as the rectangular parallelepiped and the cube may have chamfered edge and/or vertex.

When the shape of the thermoelectric conversion element is a rectangular parallelepiped, the specific orientation of the thermoelectric conversion element is difficult to be recognized from the surface shape, and particularly when the shape of the thermoelectric conversion element is a cube, the specific orientation of the thermoelectric conversion element cannot be recognized from the surface shape. Therefore, it is particularly useful in the case of a rectangular parallelepiped that the specific orientation of the thermoelectric conversion element can be recognized by using the difference of reflectances, and it is extremely useful in the case of a cube.

The thermoelectric conversion module according to the present invention comprises a plurality of p-type thermoelectric conversion elements and a plurality of n-type thermoelectric conversion elements, and a plurality of electrodes connecting the end faces of each pair of the plurality of the p-type thermoelectric conversion elements and the plurality of the n-type thermoelectric conversion elements electrically with each other to connect the plurality of the p-type thermoelectric conversion elements and the plurality of the n-type thermoelectric conversion elements electrically in series alternately, wherein at least one of the n-type thermoelectric conversion elements and the p-type thermoelectric conversion elements is hexahedral in shape, the two faces opposing each other are different in reflectance to light from the other four faces, and the two faces opposing each other are individually bonded to the electrodes.

In the thermoelectric conversion module according to the present invention, since the above described two opposing faces of the thermoelectric conversion elements are bonded to the electrode, the specific orientations of the thermoelectric conversion elements are easily arranged so as to be aligned along the flow of heat. The power generation efficiency of a thermoelectric conversion module constituted of a plurality of thermoelectric conversion elements can be easily enhanced by arranging the specific orientations of the individual thermoelectric conversion elements so as to be aligned in the direction of the flow of heat.

Furthermore, the method according to the present invention for manufacturing a thermoelectric conversion module comprises a step of measuring and comparing the reflectances of at least two faces being in contacted with each other of the above described thermoelectric conversion element, and a step of recognizing a specific orientation of the thermoelectric conversion element in which orientation a temperature difference should be applied on the basis of the comparison result of the reflectances.

According to the present invention, if a relationship of magnitude of reflectances to light between the two faces opposing each other and the other four faces of a thermoelectric conversion element whose shape is a hexahedron is previously known, the above described specific orientation of the thermoelectric conversion element can be recognized by measuring and comparing the reflectances of at least two faces being in contact with each other, and the specific orientation of the thermoelectric conversion element can be arranged in the direction of the flow of heat, on the basis of the comparison result of the measured reflectances. Thereby, it becomes possible to arrange a plurality of thermoelectric conversion elements constituting a thermoelectric conversion module along such a direction that the thermoelectric conversion element can exert the most excellent performance and to enhance the power generation efficiency of the thermoelectric conversion module.

### Brief Description of the Drawings

Figure 1 is a perspective view in one example of a thermoelectric conversion element 10 according to an embodiment of the present invention;

Figure 2 is a sectional view in one example of a thermoelectric conversion module 1 using a thermoelectric conversion element 10 according to an embodiment of the present invention;

Figure 3 is a sectional view in another example of a thermoelectric conversion module 1 using a thermoelectric conversion element 10 according to an embodiment of the present invention;

Figure 4 is a schematic view in one example of a method for manufacturing a thermoelectric conversion module using a thermoelectric conversion element 10 according to an embodiment of the present invention; and

Figure 5 is a schematic view in one example of vacuum tweezers 24 depicted in Figure 4.

### Description of Symbols

1 Thermoelectric conversion module, 2 first substrate, 3 p-type thermoelectric conversion element, 4 n-type thermoelectric conversion element, 6 second electrode, 7 second substrate, 8 first electrode, 9 bonding member, 10 thermoelectric conversion element, 12 supporting frame, a1, a2 two opposing faces, b1, b2, b3, b4 the other four faces.

### Best Modes for Carrying Out the Invention

Preferred embodiments according to the present invention will be described below in detail with reference to the attached drawings. In the description for the drawings, the same reference numerals will be put on the same or corresponding element, and overlapping descriptions will be omitted. In addition, a dimensional ratio in each drawing does not necessarily match an actual dimensional ratio.

Thermoelectric conversion element

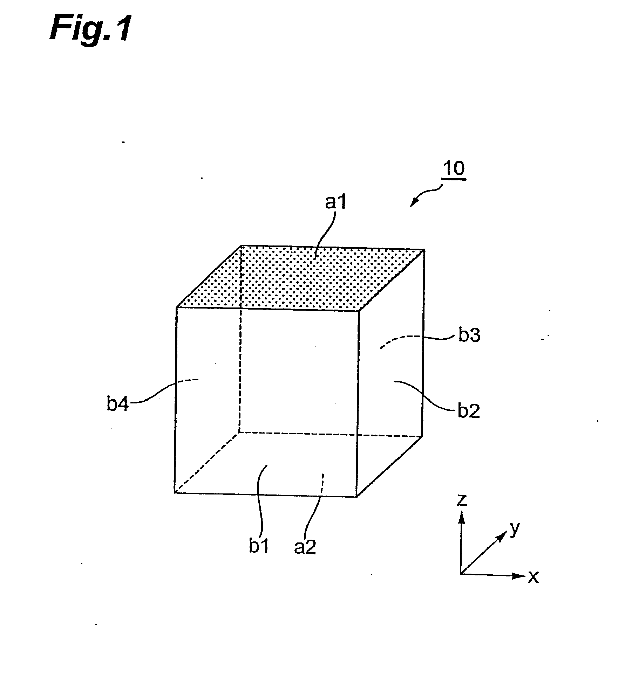

Figure 1 is a perspective view in one example of a thermoelectric conversion element 10 according to an embodiment of the present invention. The thermoelectric conversion element according to the present invention is a hexahedron as depicted in Figure 1, for instance; and two opposing faces a1 and a2 and the other four faces b1, b2, b3 and b4 are different in reflectance to light from each other. In Figure 1, the reflectances of the face a1 and the face a2 are equal to each other. On the other hand, the reflectances of the faces b1, b2, b3 and b4 are all equal to each other.

The reflectance is the ratio of the intensity of reflected light to the intensity of incident light. The light may be any of visible light, infrared light and ultraviolet light, but when the reflectance of the two faces a1 and a2 and that of the four faces b1 to b4 are compared, the reflectances need to be compared at the same wavelength. This is because the reflectance to light depends on the wavelength of the light to be applied, as well.

The shape of the thermoelectric conversion element 10 is not limited in particular as long as the shape is a hexahedron, but it is preferably a rectangular parallelepiped whose specific orientation is difficult to be recognized from the surface shape, and it is particularly preferably a cube whose specific orientation cannot be recognized from the surface shape.

The thermoelectric conversion elements 10 include two types, which are a p-type thermoelectric conversion element and an n-type thermoelectric conversion element. The materials constituting each thermoelectric conversion element 10 are not limited in particular, and various materials, such as a metal and a metal oxide, can be used.

There are the following materials as preferred materials of the p-type thermoelectric conversion element and the n-type thermoelectric conversion element.

Examples of the p-type materials include a mixed metal oxide such as $NaCo_2O_4$ and $Ca_3Co_4O_9$; a silicide such as $MnSi_{1.73}$, $Fe_{1-x}Mn_xSi_2$, $Si_{0.8}Ge_{0.2}$ and $\beta$-$FeSi_2$; and a skutterudite such as $CoSb_3$, $FeSb_3$ and $RFe_3CoSb_{12}$ (R represents La, Ce or Yb); and an alloy containing Te such as $BiTeSb$, $PbTeSb$, $Bi_2Te_3$ and $PbTe$.

Examples of the n-type materials include a mixed metal oxide such as $SrTiO_3$, $Zn_{1-x}Al_xO$, $CaMnO_3$, $LaNiO_3$, $BaTiO_3$ and $Ti_{1-x}Nb_xO$; a silicide such as $Mg_2Si$, $Fe_{1-x}CO_xSi_2$, $Si_{0.8}Ge_{0.2}$ and $\beta$-$FeSi_2$; a skutterudite; a clathrate compound such as $Ba_8Al_{12}Si_{30}$ and $Ba_8Al_{12}Ge_{30}$; a boron compound such as $CaB_6$, $SrB_6$, $BaB_6$ and $CeB_6$; and an alloy containing Te such as $BiTeSb$, $PbTeSb$, $Bi_2Te_3$ and $PbTe$.

It is preferable that the p-type thermoelectric conversion element and the n-type thermoelectric conversion element contain particularly a metal oxide among the above described materials.

Subsequently, a method for manufacturing such a thermoelectric conversion element will be described. Firstly, the thermoelectric conversion element 10 having a shape like that illustrated in Figure 1 is cut out from a matrix of a material for a thermoelectric conversion element. The matrix of the material for a thermoelectric conversion element has crystal anisotropy, and the thermoelectric conversion element 10 which has been cut out from the matrix has also anisotropy. At this time, if an orientation in which should be applied a temperature difference necessary for generating a thermal electromotive force most efficiently (i.e. a specific orientation) is a Z direction given in Figure 1, the matrix is preferably cut out so that the two faces a1 and a2 perpendicular to this Z direction can be formed. Here, suppose in the present embodiment that the two faces a1 and a2 are faces to be bonded to electrodes, and that when a temperature difference has been vertically applied to the faces a1 and a2, the thermal electromotive force can be generated most efficiently in comparison with a case of applying a similar temperature difference between other two faces.

Next, the reflectance to light of the two faces a1, a2 and that of the other four faces b 1 to b4 are made different from each other. Examples of the method of making the reflectance to light of the two faces a1, a2 and that of the other four faces b1 to b4 different from each other include a method by polishing. Specifically, a polishing method for polishing conventional metal or ceramic material, such as polishing methods using waterproof paper, abrasive cloth or electrolytic polishing, can be used. The more the faces are polished so that the surface roughness may become smaller, the more the reflectance to light increases.

Although the whole of the thermoelectric conversion element 10 is formed of a thermoelectric material that shows a thermoelectric effect, the reflectance to light can be changed by laminating a thermoelectric material on two faces of six faces, the material being different from that of the other four faces.

Thermoelectric conversion module

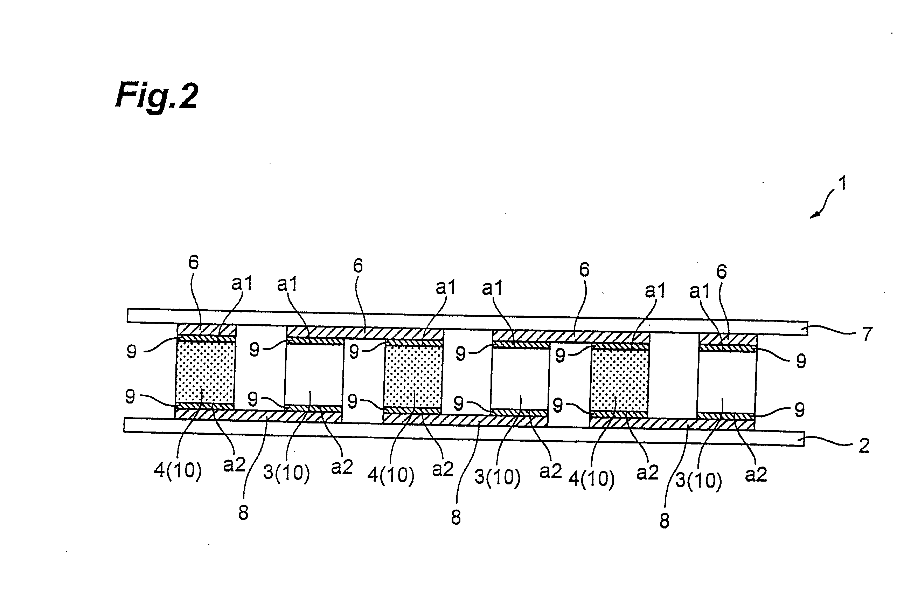

Subsequently, one example of the thermoelectric conversion module 1 using the above described thermoelectric conversion element 10 will be described. Figure 2 is a sectional view of the thermoelectric conversion module 1 using the above described thermoelectric conversion element 10. As is illustrated in Figure 2, the thermoelectric conversion module 1 has a first substrate 2, a first electrode 8, the thermoelectric conversion element 10, a second electrode 6 and a second substrate 7.

The first substrate 2 has, for instance, a rectangular shape, has electrically insulating properties and thermal conductivity, and covers one end of each of thermoelectric conversion elements 10. Examples of materials for this first substrate include alumina, aluminum nitride and magnesia.

The first electrode 8 is provided on the first substrate 2, and electrically connects one end face with one end face of mutually adjacent thermoelectric conversion elements 10. This first electrode 8 can be formed at a predetermined position on the first substrate 2 by using such a method as a thin-film forming technique such as sputtering and vapor deposition, screen printing, plating, and thermal spraying. Alternatively, a metal plate or the like having a predetermined shape may be bonded onto the first substrate 2 by soldering, brazing or the like. Although the material of the first electrode 8 is not limited in particular as long as the material has electroconductivity, it is preferably a metal containing at least one element selected from the group consisting of titanium, vanadium, chromium, manganese, iron, cobalt, nickel, copper, molybdenum, silver, palladium, gold, tungsten and aluminum as a main component from the viewpoint of enhancing the heat resistance, the corrosion resistance and the adhesiveness to the thermoelectric element of the electrode. The main component referred to herein means a component, the content of which in the electrode material is 50% by volume or more.

The second substrate 7 has, for instance, a rectangular shape, and covers the other end of each of the thermoelectric conversion elements 10. The second substrate 7 is arranged in parallel to the first substrate 2 so as to face the first substrate 2. The second substrate 7 is not limited in particular as long as the second substrate 7 has electrically insulating properties and thermal conductivity similarly to the first substrate 2, and such materials as alumina, aluminum nitride and magnesia can be used therefor.

The second electrode 6 electrically connects the other end face with the other end face of mutually adjacent thermoelectric conversion elements 10, and it can be formed on the lower face of the second substrate 7, by such a method as a thin-film forming technique such as sputtering and vapor deposition, screen printing, plating, and thermal spraying. The thermoelectric conversion elements 10 are electrically connected in series by this second electrode 6 and the first electrode 8 provided in the lower end face side of the thermoelectric conversion elements 10.

The p-type thermoelectric conversion element 3 and the n-type thermoelectric conversion element 4 are alternately arranged side by side between the first substrate 2 and the second substrate 7, and both faces of each element are fixed on the surfaces of the corresponding first electrode 8 and the second electrode 6 by a bonding member 9 formed of an AuSb-based or PbSb-based solder, a silver paste or the like. Consequently, the conversion elements are electrically connected in series as a whole. This bonding member is preferably solid while being used as a thermoelectric conversion element module.

In a plurality of p-type thermoelectric conversion elements 3 and a plurality of n-type thermoelectric conversion elements 4 which constitute the thermoelectric conversion module 1, two mutually opposing faces a1 and a2 of each thermoelectric conversion element 10 are bonded to the electrodes 6 and 8, for instance, through a bonding member 9.

The two opposing faces a1, a2 and the other four faces b1 to b4 have reflectances different from each other. Many thermoelectric conversion elements have anisotropy, and in order that thermoelectric conversion element generates electricity most efficiently, a temperature difference needs to be applied to a specific orientation of a thermoelectric conversion element. Accordingly, in order to enhance the efficiency of a thermoelectric conversion module, it is necessary to match the direction of a flow of heat in the thermoelectric conversion module to a specific orientation in which a temperature difference in the thermoelectric conversion element constituting this thermoelectric conversion module should be applied. The specific orientation of the thermoelectric conversion element in which a temperature difference should be applied, according to the present embodiment can be easily recognized on the basis of the difference of the reflectances as will be described later. In other words, it can be recognized which faces are the faces a1 and a2. Thereby, the two faces a1 and a2 can be arranged so as to be bonded with electrodes, and the specific orientation of each thermoelectric conversion element can be easily arranged so as to be aligned in the direction of the flow of heat. Accordingly, the thermoelectric conversion element can exhibit its inherent performance maximumly, and can enhance the power generation efficiency of the thermoelectric conversion module. In the present embodiment, although the direction of the flow of heat is, for example, a vertical direction in Figure 2, it is not limited particularly to this.

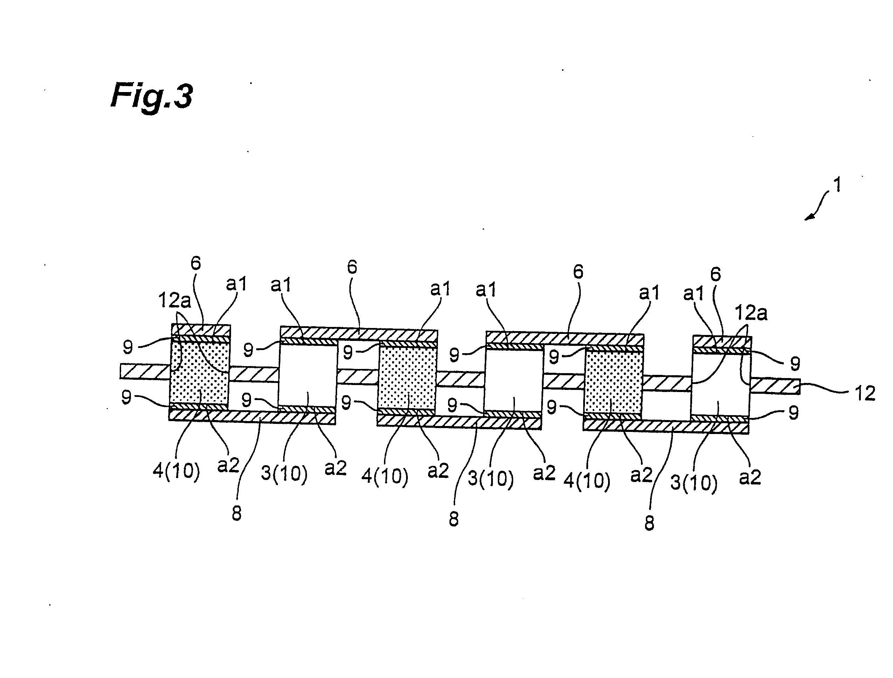

The thermoelectric conversion module according to the present invention is not necessarily limited to the above described embodiment. A sectional view in one example of a so-called skeleton type thermoelectric conversion module 1 with the use of the above described thermoelectric conversion element 10 is illustrated in Figure 3. A point at which Figure 3 is different from Figure 2 is that a thermoelectric conversion module 1 does not have a pair of facing substrates 2 and 7 and instead is provided with a supporting frame 12 intervening between the plurality of the thermoelectric conversion elements 10, holding the central portion in the height direction of each of the thermoelectric conversion elements 10 so as to surround them, and fixing each thermoelectric conversion element at an appropriate position, and the other structures thereof are similar to those of the thermoelectric conversion module in Figure 2.

The supporting frame 12 has thermally insulating properties and electrically insulating properties. A plurality of insertion holes 12a are in the supporting frame 12 at respective positions for the thermoelectric conversion elements 10 to be arranged. The insertion holes 12a have a shape of a square, a rectangle or the like, which corresponds to the sectional shape of the thermoelectric conversion elements 3 and 4.

In these insertion holes 12a, each thermoelectric conversion element 10 is fit. Then, the space between the inner wall face of a insertion hole 12a and the side face of a thermoelectric conversion element 10 is so narrow that the supporting frame 12 can hold and fix the plurality of the thermoelectric conversion elements 10. If necessary, the thermoelectric conversion elements 10 can be fixed more strongly as well, for instance, by charging an adhesive or the like onto the inner wall faces of the insertion holes 12a. Thus, the thermoelectric conversion elements 10 are held by the supporting frame 12.

The material of this supporting frame 12 is not limited in particular as long as the material has thermally insulating properties and electrically insulating properties, and a resin material and a ceramic material, for instance, can be used as the material. The material of the supporting frame 12 may be appropriately selected from among materials which do not melt at an operating temperature of the thermoelectric conversion module 1. For instance, polypropylene, ABS or polycarbonate may be used when the operating temperature is room temperature, super engineering plastic such as polyamide, polyimide, polyamidoimide and polyether ketone may be used when the operating temperature is room temperature to approximately 200°C, and a ceramic material such as alumina, zirconia and cordierite may be used when the operating temperature is approximately 200°C or higher. These materials are used singly or two or more of them are used in combination.

It is possible to easily produce a thermoelectric conversion module in which the specific orientation of a plurality of thermoelectric conversion elements 10 have been arranged to be aligned in the direction of a flow of heat by using the above described thermoelectric conversion elements 10 and bonding the two faces 1a and 1b with an electrode in such a thermoelectric conversion module. Therefore, a thermoelectric conversion module with high power generating efficiency can be produced.

In the above described skeleton type of the thermoelectric conversion module, a plurality of thermoelectric conversion elements 10 and a plurality of electrodes 6, 8 are not sandwiched between substrates 2,7 as in the thermoelectric conversion module illustrated in Figure 2, and accordingly the thermoelectric conversion module is useful in that it can reduce a heat stress which acts on each thermoelectric conversion element 10 and it can reduce a contact heat resistance.

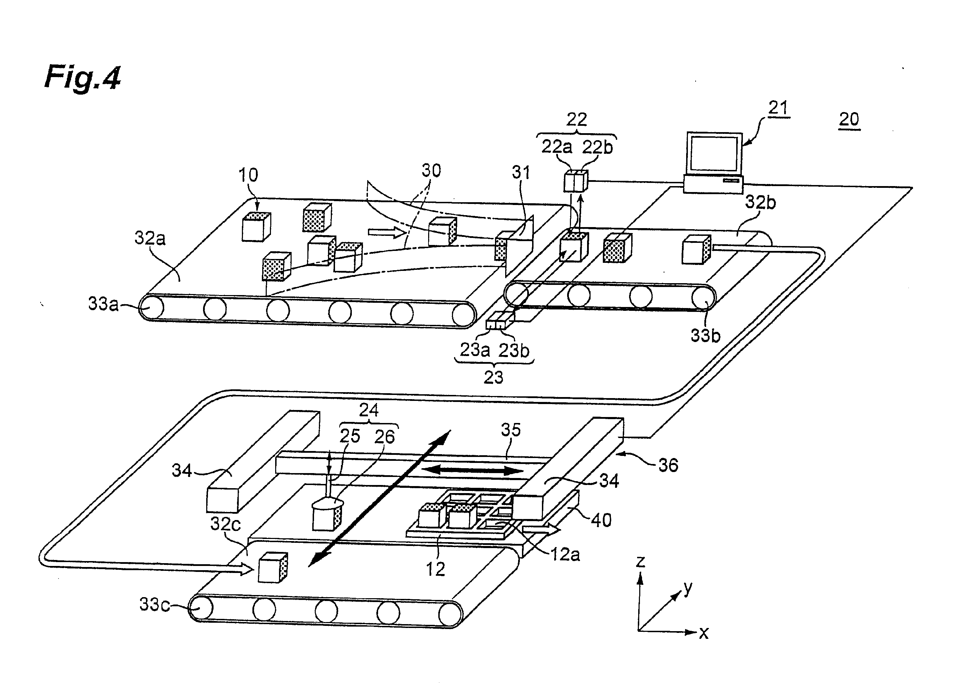

Method for manufacturing thermoelectric conversion module
Subsequently, one example of the method for manufacturing the thermoelectric conversion module by the use of the thermoelectric conversion element according to the present invention is illustrated in Figure 4. In the present embodiment, the method for manufacturing a thermoelectric conversion module of a skeleton type like that illustrated in Figure 3 will be described in detail.

The method for manufacturing the thermoelectric conversion module by the use of the thermoelectric conversion element 10 whose two opposing faces a1, a2 and the other four faces b1 to b4 have different reflectances to light from each other includes, for instance, the following steps. Specifically, a system 20 of manufacturing the thermoelectric conversion module illustrated in Figure 4 includes a step of aligning thermoelectric conversion elements 10, a step of measuring the intensity of reflected light, a step of recognizing orientation, and a step of rearranging the thermoelectric conversion elements.

Firstly, in the step of aligning the thermoelectric conversion elements 10, a plurality of the above described thermoelectric conversion elements 10 are arranged in a line.

The step of aligning the thermoelectric conversion elements 10 can be realized by using a belt conveyor 33a on which the plurality of the thermoelectric conversion elements 10 are mounted, two plates 30 horizontally facing for arranging the thermoelectric conversion elements 10 in a line, and a shutter 31 for making one thermoelectric conversion element 10 wait for a fixed period of time.

On the top face 32a of the belt conveyor 33a, a plurality of the produced thermoelectric conversion elements 10 are mounted each in a random orientation. The plurality of the thermoelectric conversion elements 10 which are widely mounted on the upper face 32a are also moved in the arrow direction by the belt conveyor 33a.

Two plates 30 are arranged on the upper face 32a so as to face each other in the horizontal direction. The distance between the two plates in the horizontal direction is narrowed gradually toward the flow direction of the belt conveyor 33a, and the width of the narrowest portion is set so as to be approximately equal to the width of the thermoelectric conversion elements 10. Thereby, the thermoelectric conversion elements 10 which have been widely mounted on the upper face 32a are aligned in a line by hitting the two plates 30 with traveling in the flow direction.

The thermoelectric conversion elements 10 aligned in a line are made wait for a fixed period of time by the shutter 31 before traveling to a next step, which will be described later. The shutter 31 is an automatically sliding plate which is installed in a further downstream side of a portion at which the distance between the two plates 30 is narrowest. This shutter 31 can make the thermoelectric conversion element 10 wait for the fixed period of time in order to send out the thermoelectric conversion elements 10 aligned between the plates 30 sequentially one by one to the belt conveyor 33b in the next step.

Next, in the step of measuring the intensity of reflected light of the thermoelectric conversion element 10, the reflectance of each element is measured by two reflectance sensors 22 and 23.

In the step of measuring the reflectance, the above described shutter 31 opens, one thermoelectric conversion element 10 flows on the upper face 32b of the belt conveyor 33b and when it reaches a predetermined position, the two reflectance sensors 22 and 23 which can measure reflectance measure the reflectances of at least adjacent two faces of the thermoelectric conversion element 10. The measurement result of the reflectances of the two faces is transmitted to a computer 21.

The reflectance sensor 22 includes a light irradiation unit 22a which makes light having a specific wavelength be incident on the upper face of the thermoelectric conversion element 10, and a light-receiving unit 22b which receives reflected light with respect to the incident light. The light irradiation unit 22a makes light having a predetermined intensity be incident vertically on the upper face of the thermoelectric conversion element 10. The light-receiving unit 22b measures the intensity of the reflected light which has been emitted almost vertically from the irradiated face of the thermoelectric conversion element 10. In addition, the reflectance sensor 23 has a light irradiation unit 23a which makes light having the same wavelength as that of the light irradiation unit 22a be incident vertically on any one of the side faces of the thermoelectric conversion element 10 at a predetermined intensity, and a light-receiving unit 23b which measures the intensity of the reflected light which is almost vertically reflected from the side face. By using these two reflectance sensors 22 and 23, the reflectances of the adjacent two faces of the hexahedral thermoelectric conversion element 10 can be obtained.

A reflectance can be calculated by using the ratio of the intensity of the reflected light to the intensity of the incident light when the light is irradiated to one certain face of the thermoelectric conversion element.

A relationship of magnitude between the reflectance to light of the two opposing faces a1 and a2 and that of the other four faces b1 to b4 in the thermoelectric conversion element 10 has previously been grasped in a step of manufacturing the thermoelectric conversion element and memorized by the computer 21. Therefore, the computer 21 can recognize the specific orientation of the thermoelectric conversion element 10 in the step of recognizing the orientation on the basis of each reflectance of the two faces of the thermoelectric conversion element 10 measured by the reflectance sensors 22 and 23.

Here, the principle of the recognition will be described in detail. The comparison result on the reflectances of two faces of one thermoelectric conversion element 10, which have been measured by the reflectance sensors 22 and 23, can be considered in two ways. There are specifically a case in which the reflectances of the two faces are the same, and a case in which the reflectances of the two faces are different. Since an error is included in the measurement result of the reflectance of each face, if the difference between the reflectances is a predetermined threshold or less (1% or less, for instance), the reflectances can be recognized to be the same.

When the reflectances of the measured two faces are different, and if the reflectance of the two faces a1 and a2 was previously set to be higher than the reflectance of the other four faces b1 to b4, the faces having the higher reflectance can be recognized to be the faces a1 and a2 of Figure 1, in other words, the faces to be bonded with an electrode. Thus, the specific orientation of the thermoelectric conversion element can be recognized.

When the reflectances of the measured two faces are different, and if the reflectance of the two faces a1 and a2 was previously set to be lower than the reflectance of the other four faces b 1 to b4, the faces having the lower reflectance can be recognized to be the faces a1 and a2 of Figure 1.

Furthermore, when the reflectances of the measured two faces a1 and a2 are the same, two faces at a position vertical to the two faces, the reflectances of which have been measured, can be recognized to be the faces a1 and a2 of Figure 1, even if a relationship of magnitude between reflectances of the two faces a1, a2 and the other four faces b1 to b4 was previously set in any way.

Thereby, it can be recognized which face among the upper face and the four side faces of the thermoelectric conversion element 10 mounted on the belt conveyors 33b or 33c is the face a1 or the face a2. Thus, the recognition result of the specific orientation recognized by the computer 21 is used for the control of a thermoelectric conversion element arrangement device 36 which will be described later.

When calculating a reflectance, the above described reflectance sensors 22 and 23 themselves may be provided with a function of directly calculating the reflectance, but the computer 21 itself may calculate the reflectance on the basis of the intensity of the incident light emitted from the light irradiation units 22a and 23a, and the intensity of the reflected light observed in the light-receiving units 22b and 23b. When the incident light on each face from the light irradiation unit 22a and 23a has the same intensity, the reflectances result in having been compared by comparing the intensities of the reflected light.

After the measurement of reflectances by the reflectance sensors 22 and 23, the thermoelectric conversion element 10 which is mounted on the upper face 32b of the belt conveyor 33b travels in the arrow direction with its orientation kept and travels to the upper face 32c of a next belt conveyor 33c. When a fixed period of time has passed and the shutter 31 is opened to transfer the thermoelectric conversion element 10 as the next measurement target to the upper face 32b from the upper face 32a, the reflectances of the two faces of the next thermoelectric conversion element 10 are measured by the reflectance sensors 22 and 23.

Finally, the thermoelectric conversion element arrangement device 36 sucks each thermoelectric conversion element 10, adjusts the specific orientation of the element so that the faces a1 and a2 may be arranged in the vertical direction, and then arranges this element in the supporting frame 12, according to the direction of the computer 21.

Firstly, a mounting table 40 is arranged beside the belt conveyor 33c, and a supporting frame 12 for the above described skeleton type thermoelectric conversion module is placed on the mounting table 40. The thermoelectric conversion element arrangement device 36 has vacuum tweezers 24, an x-axis portion 35 which allows the vacuum tweezers 24 to move in the x-direction and the z-direction of Figure 4, and a y-axis portion 34 which is arranged on both ends of the x-axis portion 35 and allows the x-axis portion 35 to move in the y-direction.

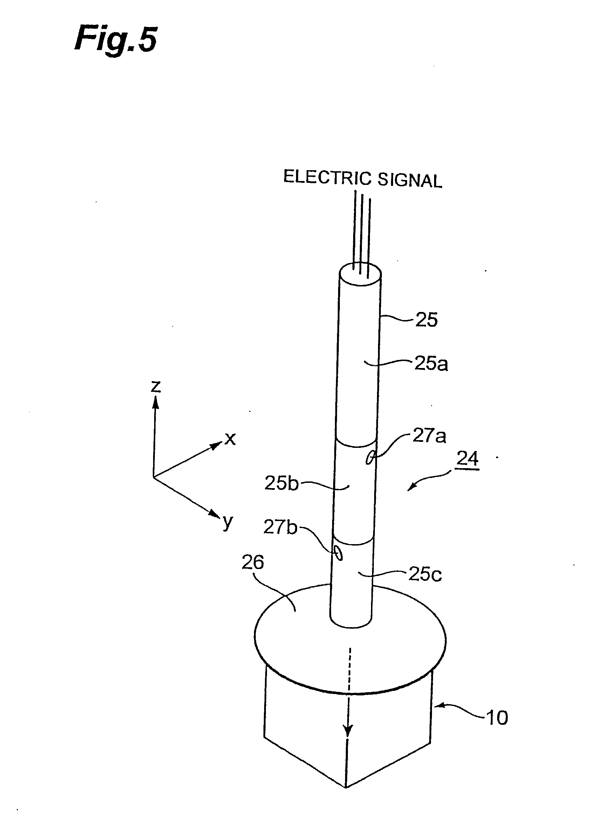

The vacuum tweezers 24 have a cylindrical arm portion 25, and a cup-shaped sucker portion 26 on the tip of the arm portion 25, as is illustrated in Figure 5. The cylindrical arm portion 25 includes three portions, i.e., a tip portion 25c, an intermediate portion 25b and a base portion 25a, sequentially from the tip side. The tip portion 25c has the sucker portion 26 fixed thereon which adsorbs one face of the thermoelectric conversion element 10 through vacuum suction and can desorb the thermoelectric conversion element 10 by releasing the vacuum state. The intermediate portion 25b and the tip portion 25c are connected through a joint 27b which allows the tip portion 25c to rotate by $\pm 180$ degrees with respect to the intermediate portion 25b around an x-axis. The base portion 25a and the intermediate portion 25b are connected through a joint 27a which allows the intermediate portion 25b to rotate by $\pm 180$ degrees with respect to the base portion 25a around a y-axis. Thereby, the vacuum tweezers 24 can change the position of the sucker portion 26 by bending the joints 27a and 27b as needed, and can adsorb an arbitrary face of the upper face and the side faces of the thermoelectric conversion element 10 on the belt conveyor 33c.

Thus, the face a1 or a2 to be bonded with the electrode is selectively adsorbed by the vacuum tweezers 24 on the basis of the recognition for the specific orientation by the computer 21. If the upper face of the thermoelectric conversion element 10 on the belt conveyor 33c is recognized to be the face a1 or a2, the vacuum tweezers 24 suck the upper face of the element. On the other hand, if any one of the side faces of the thermoelectric conversion element 10 is recognized to be the face a1 or a2, the vacuum tweezers 24 bend the joints 27a and 27b as needed, and suck the side face. Subsequently, the vacuum tweezers 24 is pulled up by the x-axis portion 35, so that the thermoelectric conversion element 10 is lifted in a z-direction, and when the joints 27a and 27b are bent, the bending of the joints 27a and 27b is subsequently released, and thereby the element is arranged so that the upper face of the thermoelectric conversion element 10 may be the face 1a or 2a. Thus, the rearrangement of the specific orientation of the thermoelectric conversion element 10 into the direction of the flow of heat is completed. Subsequently, the x-axis portion 35 and the y-axis portion 34 are driven to move the thermoelectric conversion element 10 to above a predetermined insertion hole 12a of the supporting frame 12. Then, the vacuum tweezers 24 are moved downwardly to insert the thermoelectric conversion element 10, the orientation of which has been correctly directed, into the insertion hole 12a.

The thermoelectric conversion element 10 includes two types, i.e., a p-type thermoelectric conversion element 3 and an n-type thermoelectric conversion element 4. Accordingly, in order to arrange the p-type thermoelectric conversion element and the n-type thermoelectric conversion element alternately and correctly, it is acceptable, for instance, to firstly arrange the thermoelectric conversion elements 10 of either one type in every other insertion holes 12a of the supporting frame 12, and carry out a similar step on the thermoelectric conversion elements 10 of the other type when half of all the insertion holes 12a has been filled.

Afterward, in order to finally complete a thermoelectric conversion module, it is acceptable to bond electrodes with the thermoelectric conversion elements. Thereby, a thermoelectric conversion module which can enhance power generating efficiency can be manufactured.

The above described supporting frame 12 may not be a frame for strongly fixing and holding the thermoelectric conversion element 10 which is used in a skeleton type thermoelectric conversion module. For instance, when manufacturing a thermoelectric conversion module having a structure in which a plurality of thermoelectric conversion elements are sandwiched between opposing substrates as illustrated in Figure 2, it is acceptable to form the insertion hole 12a of this supporting frame 12 so as to be sufficiently larger than the contour of the thermoelectric conversion element, further to previously arrange one substrate provided with the electrodes under the supporting frame 12 and arrange the thermoelectric conversion elements on the electrodes at a predetermined orientation through the insertion holes 12a, and to remove the supporting frame in a following step, subsequently mount the other substrate above the elements and bond the electrodes with the elements. At this time, the supporting frame 12 can be used as a frame for temporarily holding the thermoelectric conversion elements so as not to topple down or move during operation. It is also possible to use a simple container provided with a frame in place of the supporting frame 12 in order to only align the thermoelectric conversion element at a desired orientation in the present step, and to use another device in the step of arranging the thermoelectric conversion element 10 into the frame or in the step of arranging the thermoelectric conversion element 10 on the electrode.

If a relationship of magnitude between the reflectance of the two opposing faces a1 and a2 in the thermoelectric conversion element 10, in other words, the two faces a1 and a2 which come into contact with bonding members or electrodes in being assembled into the thermoelectric conversion module, and the reflectance of the other four faces b1 to b4 has previously been recognized as described above, the specific orientation can be recognized by measuring only the adjacent two faces, but even if the relationship of magnitude between the reflectance of the two faces a1, a2 and that of the other four faces b1 to b4 is unknown, the specific orientation of the thermoelectric conversion element 10 can be decided by measuring the reflectances of three faces and comparing the reflectances.

In the above description, preferred embodiments according to the present invention were specifically illustrated, but the present invention is not limited to these embodiments. Particularly, it goes without saying that the method for manufacturing a thermoelectric conversion module can be applied to a thermoelectric conversion module in which a plurality of thermoelectric conversion elements 10 are sandwiched between two opposing substrates as illustrated in Figure 2, in other words, a thermoelectric conversion module in which a substrate, an electrode, a bonding member and a frame for temporarily holding thermoelectric conversion elements so as not to topple down are stacked in this order. In addition, the present invention is not limited to the above described embodiments, and variously modified embodiments can be used.

## Industrial Applicability

The present invention provides a thermoelectric conversion element, the specific orientation of which can be easily arranged in the direction of a flow of heat, even if the specific orientation is difficult to be recognized from the surface shape of the thermoelectric conversion element. The present invention also provides a thermoelectric conversion module using the thermoelectric conversion element, and a method for manufacturing the thermoelectric conversion module.

## Claims

1. A thermoelectric conversion element, wherein the shape thereof is a hexahedron and two faces opposing each other are different in reflectance to light from the other four faces.

2. The thermoelectric conversion element according to claim 1, wherein the thermoelectric conversion element contains a metal oxide.

3. The thermoelectric conversion element according to claim 1 or 2, wherein the hexahedron is a rectangular parallelepiped.

4. A thermoelectric conversion module comprising:

   a plurality of p-type thermoelectric conversion elements and a plurality of n-type thermoelectric conversion elements; and
   a plurality of electrodes connecting the end faces of each pair of the plurality of the p-type thermoelectric conversion elements and the plurality of the n-type thermoelectric conversion elements electrically with each other to connect the plurality of the p-type thermoelectric conversion elements and the plurality of the n-type thermoelectric conversion elements electrically in series alternately, wherein
   at least one of the n-type thermoelectric conversion elements and the p-type thermoelectric conversion elements is hexahedral in shape, two faces opposing each other are different in reflectance to light from the other four faces, and the two faces opposing each other are individually bonded to the electrodes.

5. A method for manufacturing a thermoelectric conversion module comprising:

   a step of measuring and comparing reflectances of at least two faces being in contact with each other of the thermoelectric conversion element according to any one of claims 1 to 3; and
   a step of recognizing a specific orientation to which a temperature difference should be applied of the thermoelectric conversion element on the basis of the comparison result.

*Fig.1*

EP 2 214 220 A1

*Fig.2*

EP 2 214 220 A1

**Fig.3**

*Fig.4*

EP 2 214 220 A1

# Fig.5

ELECTRIC SIGNAL

25

25a

27a

24

25b

27b

26

25c

10

**EP 2 214 220 A1**

<div align="center">

## INTERNATIONAL SEARCH REPORT

</div>

| | International application No. |
|---|---|
| | PCT/JP2008/068811 |

**A. CLASSIFICATION OF SUBJECT MATTER**
*H01L35/32*(2006.01)i, *H01L35/34*(2006.01)i

According to International Patent Classification (IPC) or to both national classification and IPC

**B. FIELDS SEARCHED**

Minimum documentation searched (classification system followed by classification symbols)
H01L35/32, H01L35/34

Documentation searched other than minimum documentation to the extent that such documents are included in the fields searched
Jitsuyo Shinan Koho           1922-1996   Jitsuyo Shinan Toroku Koho   1996-2009
Kokai Jitsuyo Shinan Koho     1971-2009   Toroku Jitsuyo Shinan Koho   1994-2009

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>Y | JP 2003-197981 A  (Kyocera Corp.),<br>11 July, 2003 (11.07.03),<br>Claim 1; Fig. 2<br>(Family: none) | 1<br>2 |
| X<br>Y | JP 2003-218412 A  (Yamaha Corp.),<br>31 July, 2003 (31.07.03),<br>Claim 1; Fig. 1<br>(Family: none) | 1<br>2 |
| Y | JP 2006-351754 A  (Ricoh Co., Ltd.),<br>28 December, 2006 (28.12.06),<br>Claim 1<br>(Family: none) | 2 |

☐ Further documents are listed in the continuation of Box C.          ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered   to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 05 January, 2009 (05.01.09) | 13 January, 2009 (13.01.09) |

| Name and mailing address of the ISA/ | Authorized officer |
|---|---|
| Japanese Patent Office | |
| Facsimile No. | Telephone No. |

Form PCT/ISA/210 (second sheet) (April 2007)

**INTERNATIONAL SEARCH REPORT**

| International application No. |
| --- |
| PCT/JP2008/068811 |

---

**Box No. II**   **Observations where certain claims were found unsearchable (Continuation of item 2 of first sheet)**

This international search report has not been established in respect of certain claims under Article 17(2)(a) for the following reasons:

1. ☐ Claims Nos.:
   because they relate to subject matter not required to be searched by this Authority, namely:

2. ☐ Claims Nos.:
   because they relate to parts of the international application that do not comply with the prescribed requirements to such an extent that no meaningful international search can be carried out, specifically:

3. ☐ Claims Nos.:
   because they are dependent claims and are not drafted in accordance with the second and third sentences of Rule 6.4(a).

---

**Box No. III**   **Observations where unity of invention is lacking (Continuation of item 3 of first sheet)**

This International Searching Authority found multiple inventions in this international application, as follows:

See extra sheet.

1. ☐ As all required additional search fees were timely paid by the applicant, this international search report covers all searchable claims.

2. ☐ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☒ No required additional search fees were timely paid by the applicant.   Consequently, this international search report is restricted to the invention first mentioned in the claims; it is covered by claims Nos.:

Claims 1-2

**Remark on Protest**      ☐ The additional search fees were accompanied by the applicant's protest and, where applicable,
the                                    payment of a protest fee.

                                  ☐ The additional search fees were accompanied by the applicant's protest but the applicable protest
                                    fee was not paid within the time limit specified in the invitation.

                                  ☐ No protest accompanied the payment of additional search fees.

Form PCT/ISA/210 (continuation of first sheet (2)) (April 2007)

| INTERNATIONAL SEARCH REPORT | International application No. |
|---|---|
| | PCT/JP2008/068811 |

<u>Continuation of Box No.III of continuation of first sheet(2)</u>

The requirement of unity of invention (PCT Rule 13.1 based on Patent Cooperation Treaty) in an international patent application is satisfied, only if a group of inventions described in claims is so technically related as to involve one or two or more of the same or corresponding special technical features (or the technical features explicitly specifying the contribution to be made over the prior art by the individual inventions as a whole), as specified in Rule 13.2 based on Patent Cooperation Treaty.

In the present case, the technical feature common among the invention of claims 1 - 2, the invention of claim 3, the invention of claim 4 and the invention of claim 5 is the matter described in claim 1.

On the other hand, the matter described in the invention of claim 1 of the present patent application is described in Document 1: JP 2003-197981 A (Kyocera Corp.), 11 July, 2003 (11.07.03), claim 1, Fig. 2, and Document 2: JP 2003-218412 A (Yamaha Corp.), 31 July, 2003 (31.07.03), Claim 1, Fig. 1.

Hence, the aforementioned common technical matter cannot be a technique which makes any contribution over the prior art, and is not accepted as the special technical feature regulated by the aforementioned rules, since it is admitted that the common technical matter was already well known in the art at the application time of the present international patent application.

Moreover, the same or corresponding special technical features cannot be additionally found between the aforementioned individual inventions.

From the reasoning thus far made, it cannot be said that the present patent application has the same or corresponding special technical features between the aforementioned individual inventions. The individual inventions according to the claims of this international patent application do not satisfy the requirement of unity of invention, as regulated by PCT Rule 13.1 based on Patent Cooperation Treaty.

Form PCT/ISA/210 (extra sheet) (April 2007)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2007509498 A